# EUROPEAN PATENT SPECIFICATION

(11) **EP 2 718 034 B1**
(45) Date of publication and mention of the grant of the patent: **30.11.2016**
(21) Application number: 12706103.4
(22) Date of filing: 19.01.2012
(51) Int. Cl.: C22B 7/00, H05K 3/22, B09B 3/00

(54) **METHOD AND EQUIPMENT FOR PROCESSING ELECTRONIC WASTES**
VERFAHREN UND VORRICHTUNG ZUR VERARBEITUNG VON ELEKTRONISCHEM ABFALL
PROCÉDÉ ET APPAREILLAGE POUR LE TRAITEMENT DE DÉCHETS ÉLECTRONIQUES

(30) Priority: 10.06.2011 HU P1100308
(43) Date of publication of application: 16.04.2014
(73) Proprietor: EWR-Hungary Kft., 1137 Budapest (HU)
(72) Inventor: SZALAY, Csaba, H-1105 Budapest (HU); KOCSIS, László, H-5000 Szolnok (HU); PARTI, Judit, H-8630 Balatonboglár (HU); SZLÁVIK, Alajos, H-5008 Szolnok (HU); HARTAINÉ, Fábry Mária, H-1161 Budapest (HU); SZINAY, Zoltán, H-2330 Dunaharaszti (HU)
(74) Representative: Derzsi, Katalin
(86) International application number: PCT/HU2012/000006
(87) International publication number: WO 2012/168744

(56) References cited:
- DE-A1- 19 522 064
- DE-A1- 19 548 213

## Description

The invention relates to a method and equipment for processing electronic wastes.

It is known that nowadays the electric and electronic equipments inseparably belong to our everyday life; in each field of our life, i.e. in the work, in the household, in the show business, in car driving, in the sport, etc. such equipments, devices are surrounding us.

The manufacturers put newer and newer products to the markets, therefore the majority of the electric and electronic devices is ab ovo "disposable", but naturally the products of a higher standard are also disposed within a certain time, partly because of wearing out, partly because they are replaced by more modern devices.

Therefore it would be necessary to handle these wastes satisfactorily, environmentally friendly.

The printed circuit boards to be disposed also belong into the group of such kind of wastes. These are considered to be dangerous wastes, because of their heavy metal (Cd, Ni, Pb, Sn, Zn) content, and because they contain halogenated flame retardant additives.

In the first step of the treatment of the wastes the parts still usable or reusable are expediently removed. The electric and electronic waste - essentially the last one is considered to be the dangerous waste - are usually separated.

The effect of these dangerous wastes threatening the environment can be significantly reduced, if the organic halogen compounds, and especially the toxic heavy metal materials are somehow removed, recovered for recycling. The organic halogen compounds are generally decomposed, while the metals not decomposable are recovered.

In the course of their recycling the printed wiring boards are first milled, the pieces are separated on the basis of their material quality, using different technologies; the separated materials of different kind are processed with different procedures.

For example the international patent description published as WO 2009146175 (A2) relates to the processing method of electronic wastes, in which at least some metal is dissolved, and at least some metal is precipitated as metal oxide and/or nitrate.

The description of the patent application No. CA 2736293 (A1) outlines a procedure for processing electronic wastes, more particularly for the recovery of reusable materials, with the exclusion of toxic components, in which procedure after the separation of the toxic waste the separation is carried out on the basis of the magnetic properties.

According to the patent description No. US 2010071507 the plastic is dissolved in advance with organic solvents, and 99,99% of the metal is recovered with an electrostatic separation procedure.

According to the solution of the application No. JP 201137827 the goal is the recovery of valuable non-iron materials from electronic wastes, the treated material can even be granules of diameter below 1-2 mm, or powder. The iron is removed from the material to be treated, and they are selected on the basis of size, specific gravity; the required product is obtained with pumping.

The international application No. WO 2011011523 (A1) describes the separation of electronic wastes to metallic and non-metallic materials, based on the magnetic properties.

From the Hungarian utility sample application No. 3381 a furnace is known, for processing the chips made of resin-containing panels; this a specific, dedicated equipment, which doesn't relate to procedural (technological) solution.

Documents DE 195 22 064 A1 and DE 195 48 213 A1 disclose method and equipments for the recycling of electronic waste, the metals being recovered by thermal treatment in the first document while by electrolytic process in the second document.

Generally the disadvantage of the equipments with similar goal is that at charging, when the addition of the material is interrupted, the material block ends, additionally the reactors with conic bottom are mostly of lower mixing, therefore dumping is difficult, and in case of the reactors with plane or convex bottom closure of the boundary element is not satisfactorily foolproof.

Each of the solutions mentioned above requires comminution of the material as preparatory procedure, which generally means drastic mechanical operations (see the grinder serving this purpose, described in the international application No. WO 2010057604), while with directed procedural steps, after the separation of the waste, they want to recover certain specified materials.

Generally used method for the utilization of all the components of the electronic wastes is not known up to now.

The course and characteristics of the hydrometallurgical procedures described in the technical literature, and widely used in the practice are described by referring to flowchart "A".

It can be said, as it has already been mentioned, that in each of the currently used industrial procedures rough mechanical actions are uses in the course of the preparation. During these actions the parts made of iron and heavy metals, and the materials forming the light fractions stick. Their separation can be solved with further milling and separation operations, but the energy demand of these operations is significantly increasing the cost of the obtainable secondary raw material. As a consequence of the occurrence of the high manufacturing costs, because of the current consumption of the crushing mills, repairing/replacement of the rotating/wearing parts, and similar factors even the relatively more valuable recovery products can be produced only with increased costs.

The sequence of the actions according to flowchart "A" is the processing scheme of printed circuit (printed wiring) boards, wherein as the first step of processing the prepared coarse material obtained from the boards by crushing is heated in closed space, and treated in a suspension tub with concentrated nitric acid. Mixing used in the course of the treatment, and the concentration of the solution defines the efficiency of the process to a smaller extent, while the 60-90 °C temperature of the solution defines significantly the efficiency of the process. When concentrated solution is used, sufficient amount of solvent must be provided, which at least covers the chips, therefore measuring must be planned in each case, to determine the amount of sufficient, but not big acid surplus. The high temperature solvent almost immediately removes the varnish, but brings the metals into solution as nitrates. Following precipitation of the metal nitrates the remaining acid is neutralized with sodium hydroxide; the slag is removed from the burning furnace, and the noble metals - gold - is recovered from the ash.

The disadvantage of this solution is that since numerous industrial wastes with different composition need significantly different processing procedures, therefore it is obvious that the elaboration of universal technologies is impossible. The utilizers strive for high utilization ratio of some group of products as secondary raw material - as it can be seen from the referred technical literature sources - but this ambition runs into difficulties even because of the rough mechanical procedures mentioned above.

When the high copper and nickel content occurring in the manufacturing waste of the plant manufacturing electronic products is processed, a fine grist is prepared, and the mixed grist is treated in the suspension tub mentioned above with extremely dilute, 0,1 M sulphuric acid. Since aluminium, iron and manganese don't react when such dilute sulphuric acid is used, therefore they remain in the precipitate, but when the pH of the solution is set to 2,2 the copper can be obtained electrolytically, with high purity. The nickel is electrolyzed after alkalinization at pH 10,5. The reagent is recovered in closed cycle.

Recyclization of the soldering metals is relatively difficult to solve with hydrometallurgical procedures is rather difficult, because recovery of the three metal components in different reaction steps includes many separation and recycling operations, and because of the recovery of the alloys of different composition the determination of the cross-sections can result in industrial solution only in case of higher amounts.

Likewise in the course of the conventional procedure the grist containing soldering metal is heated together with the metals of high melting point in Caldo furnace, and since only the soldering metals melt below 600 °C, and these can be teemed from the heated slag, grist. The alloys melt at 183-400 °C, and can be discharged. The cooled residue treated in the suspension tub with nitric acid according to the above results in metal nitrates.

The objective of the invention is the elimination of the disadvantages of the solutions known from the technical literature; moreover the objective of the method and equipment of the invention, in addition to the elimination of the disadvantages of the known solutions to allow the high degree utilization of the mixed, crushed fraction of the electronic wastes in small-scale plant conditions.

According to the invention it is recognized that with the treatment of the printed wiring boards containing numerous metal components and different plastics the reusable materials can be recovered more easily than with the usual mechanical separation.

According to the invention we can proceed in such a way that the reusable metal components and other usable materials of the printed wiring board are recovered in a single technological line; this is considered to be advantageous procedure, but the metals and other usable materials can be recovered separately from the other material, called altogether light fraction.

Since it is known, that the electronic equipments, especially the IT, i.e. the equipments of the consumer electronics and office equipments, even separately may contain 200 different materials, it is understandable, that it is difficult to recover all reusable components in high purity, with sufficient utilization rate, therefore according to the invention the processing is conducted in such a way that in the phase following milling heating is used in closed atmosphere. Primarily the soldering metals must be recovered, since in the course of heating their toxic vapours need special measures. The remaining soldering metal, as it will be explained later in details, can be separated with acid treatment.

In our case definition of "light fraction", unlike the idea of the conventional waste treatment means not only plastics, since with the mechanic separation carried out with the known procedures the ceramics, minerals (pressboard), glass fibre, as inert residues, are also separated, therefore in our case the characteristics of the grist introduced into the furnace, related to heat decomposition, carbonization can be influenced in a wide range.

Therefore in the course of the procedure of the invention - in case, if the metals and the plastic based light fraction are processed separately - by knowing the manufacturing procedure, separation of the cable buttings, solder ends of the connectors, circuit components is carried out by the electrostatic separation of the residue remaining on the base board, with the quasi "shaving off" of the base boards. This last action is carried out in two steps: first with mechanical influence, i.e. with two convergent rolls the accessory parts are practically planed off, which go to further classification. On the surface of the printed wiring boards the printed wiring represent unevenness, from which the solder ends can also be removed in the form of fine grists in the course of rubbing. Separation of the copper, nickel and noble metals is carried out electrically, according to the current knowledge of the technical field; melt dischargeable at known temperature was obtained, while because of the higher lead-content of the mixtures intensive production of the second melt is carried out at higher temperature. Therefore because of the high (around 50%) lead-content of the soldering materials obtained from the Class II, epoxy resin based boards the melting temperature is significantly higher than that of the alloys prepared mainly from Sn-complement of the alloy, containing only 1-2% Zn. The co-metal of the lead, the cadmium is present in each case in its alloys, therefore both in the course of the experimental processing; both in industrial scale precipitation of its harmful vapours must be ensured.

The separation of the metals is simple, because of the magnetic characteristics of the iron, and the small specific gravity and amphoteric character of the aluminium. Hereinafter we focus to the recovery of the Cu, Ni Au - as it will be demonstrated in the examples too. Processing of the light fraction will be described in more details later on.

In the preferred embodiment of the procedure of the invention grists are prepared from the electronic wastes, mainly printed wiring boards and
i) the grists are heated in a reactor, preferably at 455-475 °C temperature, the vapours of the soldering metals leaving above 200 °C are led away, precipitated, the soldering metals are recovered, the gas generated in the reactor is lead into an alkaline quencher, where it is purified, the oil obtained is recovered, the carbon powder part of the heating residue on the bottom of the reactor is lead away, and the polymer heating residue is treated with an acidic solution; or
ii) if the metals are removed from the surface, the light fraction is crushed, for its processing for the recovery of the resin the resin is heated in a low temperature reactor, the generated gases are lead away and cooled, the solidified resin is recovered, the bottom product of the reactor is also treated with nitric acid, and the solid residue is separated.

As it has been mentioned the expression "light fraction" in our case means a composition which allows to have the characteristics of the grist introduced into the furnace, related to heat decomposition, carbonization, susceptible to influence in a wide range.

For example this way in addition to the high plastic content the valuable rare metals can be enriched with a suitable method.

According to another possibility in addition to a minimal plastic/resin content heating is carried out in the presence of all the materials, and this results in a quick reaction even at 50% metal content, since due to their excellent heat conduction the intensity of the secondary heat transfer reactions, occurring in the course of the continuous heating and stirring, is high.

In the course of pre-processing the removal of the macroscopic iron-content and the aluminium-content is possible, therefore in this step the main technological goal is the recovery of the more valuable metals in galvanic purity.

The plastic-content can be low or high, but we try to reach, that among them the ratio of the ABS, PVC, PA or rubber product be small. This is necessary, because the high ratio of the plastics listed would result in low quality liquid product, therefore after their separation a utilization different from the main technology is used from these substances, for example the fusion of the mixture with an extruder.

In the course of the thermal procedure the steps preceding the closed space heating stage are not detailed, but it must be noted, that new procedure is used at feeding.

Additionally, the invention relates to the equipment for processing electronic wastes, particularly the reactor suitable for high temperature treatment in the procedure.

The reactor of the invention includes a lower part and a dome, has a baffle blade mounted to its shaft and a driving engine, and has heating element, furnace cavity, and elements for leading away the products; the main point is that inside the feeding screw there is a closing element; the central unit of the reactor is the bearing box of the driving engine, containing double stuffing box, and the lower member of the mechanic of the stirrer is an anchor stirrer, which has dredging shovels of variable direction of rotation, with dual profile, there is a removal hole on the conoidal frustum shaped bottom of the reactor, continuing in a vertical neck.

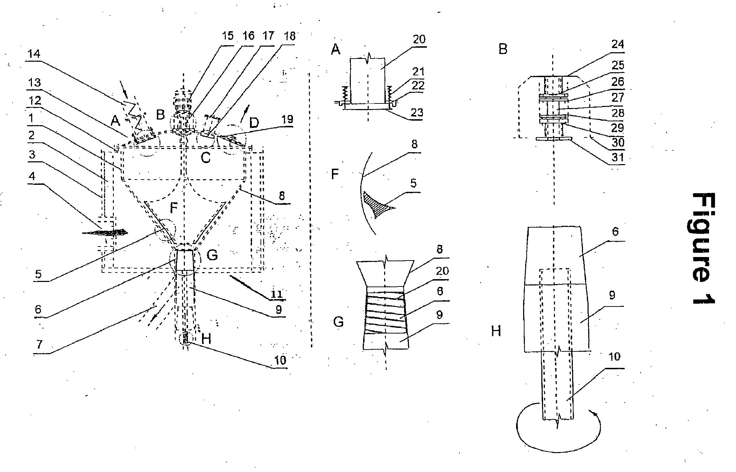

The solution of the invention will be presented in more details in relation to Figure 1, showing the cross section of the equipment of the invention, and A, B, F, G and H details of the equipment.

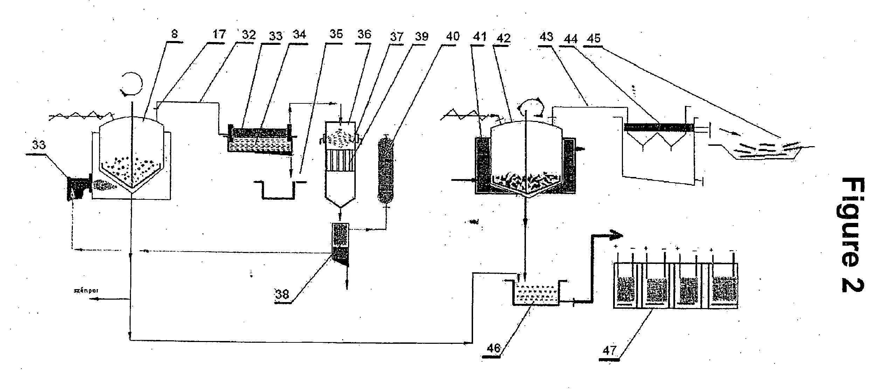

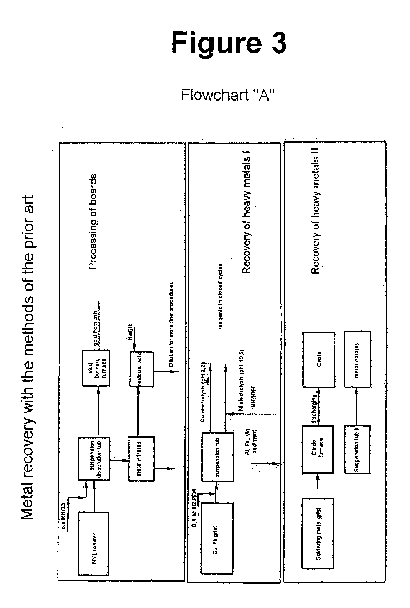

Figure 2 is the flow chart of the solution of the invention.

The A flow chart of the known solution has already been described previously, at the description of the state of the art.

The cross section of the equipment of the invention is presented on Figure 1.

It can be seen on Figure 1 that with the assistance of the means of transport the mixture adjusted according to its composition is introduced into a top hopper, from where it is fed with the 14 feeding screw into the 8 chamber of the furnace. The construction of the 13 plate lock (detail A), arranged on the lower point of the 14 feeding screw, on the 14 furnace dome is suitable by emptying the 14 feeding screw for stopping the material lock existing in the equipment, this way the 21 spring pair located on the 22 edge of the plate of the 13 plate lock closes with return, until the house of the 14 feeding screw fills with another dose of grist.

Additional characteristics of the construction of the furnace:
- the equipment includes centrally located 8 chamber, on the 12 furnace dome of which can be found the previously mentioned 13 plate lock of the feeder, the covered 19 access hole, the 17 vapour outlet, into the mouthpiece of which the 18 throttling element is put (detail D), to eliminate that the spatter caused by the sudden vapour generation introduce solid material, tending to adhere into the vapour pipe. The vapour line is attached to the 17 vapour outlet with an edge of screw joint.
- On the 3 isolated mantle of the furnace is located the 4 block burner to provide the heating power, the equipment can be for example a GB-Ganz type oil burner with 127 kW. The upper section of the 8 chamber is a 1 cylinder.

The central unit of the 12 furnace dome is the 16 bearing box of the driving engine (detail B), which includes 26, 27, 28 and 29 double stuffing box, in order to keep the gas-proofness even in extreme conditions, like for example the progressive rise of the pressure, generation of aggressive substances, etc. The 16 bearing box receives the 24 adapter edge of the 15 driving engine.

The lower part of the stirring mechanic is an anchor stirrer, whose 5 dredging shovels follow the section of the conoidal frustum shaped bottom of the 8 chamber, along its forming, in about 6-12 mm distance from it. The location of the 5 dredging shovels is adjusted by lifting at the 15 driving engine, depending on the material to be processed. In case of high metal-content the location of the shovels is upper point.

The profile of the 5 dredging shovels is different, because of the variable direction of rotation. The knife profile of the 5 dredging shovel rotates clockwise, following the conoidal frustum shaped bottom of the 8 chamber, while by rotating anti-clockwise the pushing profile of the 5 dredging shovel stirs up the material.

The lower removal hole of the 8 chamber continues in the 9 vertical neck, which is still located in the furnace chamber, in order not to generate a cold spot. The furnace chamber is limited from below by the 11 horizontal isolated sheet. The section is closed with the 6 cone lock, which, by moving up at opening stops under the mouth opening of the Y-branch, and this way the residue can be emptied here. The inclined shaft is located below the level of the water bath, in order to prevent the harmful vapour, and the vapour content of the high metal content slag converts to homogeneous fine powder as a consequence of the hidden cooling off, which can be decanted from the surface of the bath when it swims to the surface. On the skirt of the 6 cone lock a 20 spiral path with round thread is shaped. The 9 vertical neck tightens conically, but the task of the threads on the 20 spiral path is to send back the granular grist into the chamber, because when the 6 cone lock moves up during rotation, it would compress the granules to the surface of the 9 vertical neck, and this way the 20 spiral path cleans the natural valve seat in the course of closing.

The up and down moving is provided by the 10 rotating shaft with trapezoidal thread, which is operated by a reverse gear.

On the 12 furnace dome the construction of the 30 bearing box is the following: in its lower plane is located the 31 panel, which is connected with a welded bonding to the 12 furnace dome; the two, 26, 27, 28 and 29 stuffing boxes are located above it, which is attached to the axle stub of the 15 drive with a rigid coupling. The axle 10 is attached to the 15 drive with a brim.

In the following the method of the invention is further illustrated with the Examples 1 and 2, in case of Example 2 in relation to block diagram No. 1.

### Example 1

The following adjustments, measurements were made with the prototype of the equipment of the invention.

Essentially the reactor is a kettle with a self-contained studwork, limited with a furnace cavity from the side and from below, the external elements of which are provided with heat-isolation, according to the temperature set.

In the furnace cavity 650 °C is provided, within a 1% range, by the action of a regulated oil burner. The formation of the inside chamber (D=1850 mm): dome normal convex vessel bottom, connected to a flange. This last one rests on the eight legs with cantilevers, holding the total weight of the whole equipment. The chamber has conic bottom. The volume of the inside vessel is 3 m³, into which 200-400 kg doses are fed. The space filling of the material, depending on its specific gravity, is 0,8-2 m³. In the course of stirring, carried out during feeding and processing, the gas space of the vessel is very big, this allows the constant flow rate, since it is insensitive to the impulsive gas-emitting.

In the course of our first measurement 300 kg Class II electronic waste grist was fed into the chamber, the feeding plate clock was closed, and the lower conic floss hole likewise, the covered access hole was gas-proof. At this measurement preheating of the chamber was not carried out, since the 420 °C occurring in the furnace cavity 3 minutes after firing, demonstrated, that the intensive heat-transfer started immediately. The grist contained mainly chips with 20-25 mm grain size, the dust content was about 1-3%. Heating was continued until the temperature observed in the chamber reached 550 °C, this temperature was maintained, until flow was observed from the watered spray cooler to the gas afterburner. The outgoing of the gases was seen with the air motion occurring at the upper position of the fitting. At low decomposition temperature an inflammable gas was generated with ABS and styrene components, which was fired about 10 minutes later, the flame burned continuously with variable intensity, until total carbonization occurred. The process lasted for 40 minutes from the feeding.

In the course of the heating carbonization the material remaining in the chamber from 300 kg mixed grist was 153 kg, i.e. 51%, in which after visual inspection the presence of coal flour, metallic grains, ceramic, glass pieces was determined. Only 60 litres of oil-like liquid of high viscosity was decanted, and from these it was determined partly that the amount the gases leaving the cooler was 87 kg, this, by taking into consideration the theoretic composition is about 50 Nm³, and partly it was determined that the applied processing temperature is too high, therefore further on the goal of the settings was to reach and maintain the 450-470 °C.

The gas sample was collected in a balloon, and transferred into a laboratory for analytical investigation. The results of the investigation are presented in Table 1.

**Table 1**

| **Gas sample (FVM)** | | | | | | | | | | | | |
|---|---|---|---|---|---|---|---|---|---|---|---|---|
| Test results | | | | | | | | | | | | |
| Test identifier | Name | N | C | S | H | O | Cl | H:O* | Ash | Ho | Hu | Hu abs |
| | | % | % | % | % | % | % | % | % | MJ/kg | MJ/kg | MJ/kg |
| 200811141 | Secondary raw material | 0,620 | 80,416 | 0,289 | 10,233 | 3,014 | 0,588 | 1,900 | 2,940 | 41, 777 | 39,475 | 40.031 |
| 200811141 | Secondary raw material | 0,650 | 81,111 | 0,298 | 10,058 | 2,312 | 0,537 | 1,900 | 3,134 | 42,140 | 39,876 | 40,445 |
| 200811141 | Secondary raw material | 0,688 | 79,841 | 0,337 | 10,209 | 3,521 | 0,519 | 1,900 | 2,985 | 42,091 | 39,794 | 40,357 |
| | **Average** | **0,653** | **80,456** | **0,308** | **10,167** | **2,949** | **0,548** | **1,900** | **3,020** | **42,003** | **39,715** | **40,278** |

| | | | | | | | | | | | | |
|---|---|---|---|---|---|---|---|---|---|---|---|---|
| * Measurement without parallel Ho: Combustion heat belonging to the moisture content measured Hu: Caloric value belonging to the moisture content measured Hu_{abs}: Caloric value related to the solids | | | | | | | | | | | | |

| Composition | Measured | Caloric value [MJ/m³] | CH based [%] | E caloric value [MJ/m³] |
|---|---|---|---|---|
| C1 | 23,661 | 35,797 | 33,120 | 1186 |
| C2 | 13,245 | 64,351 | 18,54, | 1193 |
| C3 | 7,444 | 93,575 | 10,420 | 975 |
| C4 | 17,585 | 121,627 | 24,614 | 2994 |
| C5 | 2,850 | 144,076 | 3,990 | 575 |
| nC5 | 0,768 | 144,076 | 1,075 | 155 |
| cC5 | 0,021 | 144,076 | 0,030 | 4 |
| cC6 | 1,939 | 171,737 | 2,714 | 466 |
| nC6 | 0,390 | 171,737 | 0,546 | 94 |
| MecC5 | 0,069 | 171,737 | 0,097 | 17 |
| Benzene | 0,180 | 140,000 | 0,252 | 35 |
| CH | 0,037 | 171,739 | 0,052 | 9 |
| cC7 | 0,761 | 198,938 | 1,065 | 212 |
| nC7 | 0,191 | 198,938 | 0,267 | 53 |
| C8 | 0,291 | 224,023 | 0,07 | 91 |
| C9 | 0,024 | 246,023 | 0,407 | 91 |
| C10 | 0,002 | 266,023 | 0,03 | 1 |
| CO₂ | 21,500 | 0 | 15,357 | 1 |
| N2 | 7,056 | 0 | 5,040 | 0 |
| CO | 40,000 | 3 | 28,571 | 86 |
| | 140,000 | | | |
| | | | | |
| **Calculated caloric value** | | | | **84,97** |
| **CO₂, N₂, CO derived caloric value** | | | | **43,78** |

The 153 kg solid residue was treated in a water bath, and the coal flour content in compliance with the treatment temperature was determined. It amounted to 71 kg, which was decanted residue free with a sieve, after swimming up on the water bath. The material is measured in dry condition. After the removal of the coal flour the metal content of the remaining dry substance was 48 kg. 20 kg iron, 16 kg aluminium and about 9 kg copper could be detected in the sample. Additionally 0,16 kg silver and 0,0005 kg gold was found.

In the course of the examination of the sample it has been found that processing of Class II electronic waste raised economic problems.

Our second sample is colour grist, without preliminary examination. The fed amount is 150 kg, at chamber temperature set to 470 °C. Heating and stirring was continued for 90 minutes, gases leaving the equipment were inflammable, their amount was small. It was determined in the laboratory tests that the material studied was 100% polyamide, the thermal decomposition products are inflammable, its decomposing energy is high, therefore the material is not considered to be suitable for thermal utilization.

The third plastic sample is almost 100% ABS. In the course of its heating its decomposition starts even at 180 °C, the intensity of decomposition increased with raising the temperature. In the course of the about 25 minutes' heating light decomposition product was obtained, containing about 70% aromatic compounds, 20% aliphatic compounds, 5% flammable gas, and 5% solid residue (at the maximum). It was found that heat decomposition of the large amount of material forming the houses of the IT equipments is suitable primarily for the production of paint thinner, solvent secondary raw material, and it can be added to a liquid propellant in regulated, i.e. in prescribed amount.

In the course of the examination of the fourth sample the processes occurring during heating of the phenolic resin based boards were evaluated. This examination proves our belief, that the resin-recovery even at low temperature is suitable only if the amount of the substances is significant, and there is a willingness from a manufacturer to accept it.

### Example 2 - described on the basis of flow chart 2

In case of this example printed wiring board grist of unknown origin is processed, which contains almost all the heavy metals used in the industry. The diameter of the reactor is 1800 mm, with 2,6 m³ chamber volume with 8 chambers, which is heated with 32 oil block burner, and its operation is regulated in a way to keep the temperature of the chamber constantly between 465-475 °C. The vapours leaving over 200 °C are conducted on a 34 water heated tray. By rotating a 33 ceramic pipe in this it is reached, that the vapours of the soldering metals precipitate on the surface of the pipe. Because of the speed of the emitted gases the refrigerant capacity of the 33 ceramic pipe (d57 mm) was negligible for the precipitation of the degraded products, but as a cold point the vapours of the soldering metals precipitated. The materials are collected in the 35 tray. The gas is purified in the 36 alkaline quencher from its halogen-containing components, i.e. the fire-retardants and the hydrochloric acid content of the PVC is neutralized in the NaOH spray in the 37 spray chamber, and gives the salty sediment of its bottom container. This is periodically blown-down. In the upper part of the column (d400 x 1200 steel container) nozzles are installed, arranged in 120 degrees, which are installed with the screwed connector mounted on the outer surface of the mantle. The stability of the cooler zone is provided with about 350 high ceramic body - rushing - charge.

The quantity of the technological oil generated this way was 26 litres, around 20 kg, the amount of the gas produced can be calculated from the amount of the solid residue. Since 54 kg slag was measured, the 26 kg amount of the gas can be calculated to 14 Nm³, on the basis of the composition of the model. It was found that the 14 litres of oil used during adjustment, burned up in the 96 minutes' experiment, the quantity of the technological gas burned up in example 1 is significantly lower, than the energy-content of the mixture, therefore the conclusion is, that the degradation product originating from the 22% plastic content mixture is sufficient for carbonizing the content of the chamber, and this way for the further efficient decomposition of the metal-containing slag.

If the 22% polymer-content determined by the professional literature is considered to be average, pyrolytic processing is profitable, because of the high metal-content of the slag.

The experiments of Ni recovery were conducted both with nitric acid and sulphuric acid etching, and it was experienced that in addition to the danger of the acid treatment it leads to complex solutions, because of salting out all the metals, but the 0,1 M nitric acid salts out 94% of the Ni, and in the second salting out with 1 M solution the nitrates of Cu also salt out full quantity of the metal.

Extraction was carried out even with 1 M sulphuric acid, the Cu precipitated from its electrolyte at pH=2,2 in more than 96% amount, the electrolysis of the Ni was carried out in a slightly alkaline medium over pH=10. The aluminium and the iron did not participate in the redox processes.

The 47 plating baths were made from acid-proof polypropylene; consoles were put at the level of the rim of the tub to suspend the electrodes. The cathodes were made from the metal to be recovered in the form of rod or plate, and it was found that with suspended cathode measurement the 1, 2, 4 kg metallurgic cast sizes can be prepared with electrolysis, by monitoring the mass. The tubs were provided with a continuously regulated power supply unit of 3-46,4 V direct voltage. Since the resistance of the electrolyte is almost zero, the power supply unit works in short-circuit operational mode, the recovery of the metal from the liquid is intensive even at low voltage. About twice as much electricity is needed for the Ni (4,43 kW/kg), and at the same time its price is also significantly higher.

Experiments were performed even for the recovery of the resin, the goal of which is the recovery and recycling of the resin in the original structure.

This can be reached if it is heated over its melting temperature, but below its decomposition temperature.

The experimental setup is a 60 liters' 42 double-walled kettle, its 41 mantle is heated with MOL thermo-oil circulating on a closed vessel on the side. The temperature of the calorifier material was kept between 250-270 °C, therefore it is possible to reach 178 °C in the chamber, where the vapours of the phenolic resin exit on the 43 vapour line, this temperature was raised to 224 °C, and this resulted in the more intensive flow of the vapours. The white vapour seen in the inspection culvert is bubbled through the 44 water tub, and as a result of this the resin forms leaflike melt on the surface of the water, which was decanted in the dry 45 tub, and allowed to solidify.

The bottom product of the 42 low temperature reactor is treated in the 46 suspension tub with our procedure mentioned above (4 M nitric acid), and this way in the course of the separation of the solid residue coal flour is obtained, suitable for firing, which swam up in the rinsing water. After decanting the coal flour was dried, and fired on grid mixed with heavy oil.

In the course of the operation of the 47 plating bath a removable bottom plate was arranged in order to avoid the blowing-off of the sludge, which can be made of acid-proof steel or Teflon, and this way the acid loss reduces after the lifting of the sludge, especially as after filtration the rinsing solution is set for stock solution for the recovery of copper.

Exhaustion was carried out in different systems, depending on the solvent, and this way the aggressive substances left the working space bubbling through a neutralizing solution.

The voltage conditions of the plating bath were minimized, in order to avoid the sudden generation of gas, which would cause local risk of ignition.

On the basis of its purity it can be said, that the product obtained is a secondary product suitable for manufacturing printed wiring boards. In the course of processing the printed wiring boards the application of degradation methods is refused, because utilization of the numerous (20 different) phenol product is less hopeful. Additionally it must be mentioned that from the acid used in the course of the procedure after filtration and dilution the residual acid can be used for more delicate procedures, i.e. for soaking solving, metal cleaning; the residue is stripped, its sediment is stored.

### List of the reference numbers

| | | | |
|---|---|---|---|
| 1 | cylinder | 35 | tray |
| 2 | wall | 36 | alkaline quencher |
| 3 | mantle | 37 | spray chamber |
| 4 | block burner | 38 | head tank |
| 5 | dredging shovel | 39 | ceramic body |
| 6 | cone lock | 40 | gas tank |
| 7 | Y-branch | 41 | mantle |
| 8 | chamber | 42 | low temperature reactor |
| 9 | neck | 43 | vapour line |
| 10 | shaft | 44 | water tub |
| 11 | isolated sheet | 45 | tub |
| 12 | furnace dome | 46 | suspension tub |
| 13 | plate lock | 47 | plating bath |
| 14 | feeding screw | | |
| 15 | driving engine | | |
| 16 | bearing box | | |
| 17 | vapour outlet | | |
| 18 | throttling element | | |
| 19 | access hole | | |
| 20 | spiral path | | |
| 21 | spring pair | | |
| 22 | edge | | |
| 23 | surface | | |
| 24 | adapter edge | | |
| 25 | shaft equipment | | |
| 26, 27, 28, 29 | double stuffing box | | |
| 30 | bearing box | | |
| 31 | panel | | |
| 32 | oil block burner | | |
| 33 | ceramic pipe | | |
| 34 | tray | | |

## Claims

1. Method for processing electronic wastes, **characterized by** that the reusable metal components and other reusable components of the electronic waste are recovered in a single technological line; or
metals and other usable components are recovered separately;
so that
a/ for recovering reusable metal components and other usable components in a single technological line, grist is prepared from electronic wastes containing metals
too, and the grist is heated in a reactor, preferably at 455-465 °C temperature, the
vapours of the soldering metals exiting over 200 °C are lead away, precipitated by cooling, the soldering metals are recovered, the gas generated in the reactor from other components than metals is lead into an alkaline quencher, where it is purified, the coal portion of the heating residue remaining on the bottom of the reactor is lead away, and the polymer heating residue is treated with acidic solution, or
b/ for recovering metals and other reusable components separately, the metals are
removed from the surface of the electronic waste to be processed by
rubbing-grinding, separation of copper, nickel and noble metals is carried out electrically with a known method, this way dischargeable melt is obtained, at higher temperature the lead-containing soldering metals are recovered as secondary melt, the metals are separated, and the light fraction is crushed, heated in a low temperature reactor, in order to recover the resin, the vapours generated are lead away, cooled, the solidified resin is recovered, the bottom product of the reactor is treated with nitric acid, and the solid residue is separated.

2. Method of Claim 1, characterized that printed wiring boards are processed as electronic wastes.

3. Equipment for processing electronic wastes, including a lower part containing a chamber 8 of the furnace and a furnace dome 12 has a agitating blade 5 and a driving engine 15 mounted to its shaft 10 has a burner block 4, furnace cavity, and elements for leading away the products, and inside its feeding screw 14 there is a plate lock 13, the central unit of the reactor is the bearing box of the driving engine, containing double stuffing box 26, 27, 28 and 29, and the lower part of its stirring mechanics is an anchor stirrer, has dredging showels 5, on the conoidal frustum shaped bottom of the reactor there is a removal hole, closed by a cone 6 lock, and the removal hole continues in a vertical neck 10

4. Equipment of Claim 3, whose closing element 13 is a plate lock, with spring pair 22 located on its edge.

5. Equipment of Claim 3 or 4, in which in the mouthpiece of the vapour outlet 17, located on the furnace dome 12, there is a throttling element 18.

6. Equipment according to any of Claims 3-5, in which the dredging showels 5 have two profiles, one of them is a knife profile, and the other is a pushing profile.

7. Equipment according to any of Claims 3-6, in which there is a spiral path 20 with round thread on the mantle of the cone lock 6.

## Patentansprüche

1. Verfahren zum Verarbeiten von Elektronikabfall, **dadurch gekennzeichnet, dass** die wiederverwendbaren Metallkomponenten und andere wiederverwendbare Komponenten des Elektronikabfalls in einem einzigen Verfahrensablauf rückgewonnen werden; oder
Metalle und andere verwendbare Komponenten getrennt rückgewonnen werden;
wobei
a) zum Rückgewinnen von wiederverwendbaren Metallkomponenten und anderen verwendbaren Komponenten in einem einzigen Verfahrensablauf
Mahlgut aus Elektronikabfall, der auch Metalle enthält, hergestellt wird und das Mahlgut in einem Reaktor erhitzt wird, vorzugsweise auf eine Temperatur vcn 455-465 °C, die Dämpfe der Lötmetalle, die bei über 200 °C austreten, abgeführt werden, durch Abkühlen präzipitiert werden, die Lötmetalle rückgewonnen werden, das in dem Reaktor aus anderen Komponenten als Metallen erzeugte Gas in einen Alkaliquencher geleitet wird, in dem es gereinigt wird, der Kohleanteil des Heizrückstands, der an dem Boden des Reaktors verbleibt, abgeführt wird und der Polymer-Heizrückstand mit saurer Lösung behandelt wird, oder
b) zum getrennten Rückgewinnen von Metallen und anderen wiederverwendbare Komponenten
die Metalle von der Oberfläche des zu verarbeitenden Elektronikabfalls durch Reiben-Mahlen entfernt werden, Abtrennung von Kupfer, Nickel und Edelmetallen elektrisch durch ein bekanntes Verfahren durchgeführt wird, auf diese Weise abführbare Schmelze erhalten wird, bei höherer Temperatur die bleihaltigen Lötmetalle als sekundäre Schmelze rückgewonnen werden, die Metalle abgetrennt werden und die leichte Fraktion zerkleinert wird, in einem Niedertemperaturreaktor erhitzt wird, zum Rückgewinnen des Harzes die erzeugten Dämpfe abgeführt werden, abgekühlt wird, das erstarrte Harz rückgewonnen wird, das Bodenprodukt des Reaktors mit Salpetersäure behandelt wird und der feste Rückstand abgetrennt wird.

2. Verfahren gemäß Anspruch 1, **dadurch gekennzeichnet, dass** gedruckte Leiterplatten als Elektronikabfall verarbeitet werden.

3. Anlage zum Verarbeiten von Elektronikabfall, umfassend einen unteren Teil, der eine Kammer 8 des Ofens und eine Ofenkuppel 12 umfasst, ein Rührblatt 5 und einen an dessen Welle 10 angebrachten Antriebsmotor 15 aufweist, einen Brennerblock 4, einen Ofenhohlraum und Elemente zum Abführen der Produkte aufweist, und wobei innerhalb seiner Förderschnecke 14 eine Plattenverriegelung 13 angeordnet ist, wobei die zentrale Einheit des Reaktors das Lagergehäuse des Antriebsmotors ist, das eine doppelte Stopfbuchse 26, 27, 28 und 29 umfasst, und der untere Teil seiner Rührmechanik ein Ankerrührer ist, Baggerschaufeln 5 aufweist, wobei an dem kegelstumpfförmigen Boden des Reaktors ein von einem Kegelverschluss 6 verschlossenes Entnahmeloch angeordnet ist und sich das Entnahmeloch in einen senkrechten Hals 10 fortsetzt.

4. Anlage gemäß Anspruch 3, deren Verschlusselement 13 eine Plattenverriegelung ist, bei der ein Federpaar 22 an seiner Kante angeordnet ist.

5. Anlage gemäß Anspruch 3 oder 4, wobei in dem Mundstück des Dampfauslasses 17, der an der Ofenkuppel 12 angeordnet ist, ein Drosselelement 18 angeordnet ist.

6. Anlage gemäß einem der Ansprüche 3-5, wobei die Baggerschaufeln 5 zwei Profile aufweisen, von denen eines ein Messerprofil und das andere ein Drückprofil ist.

7. Anlage gemäß einem der Ansprüche 3-6, bei der ein spiralförmige Weg 20 mit einem Rundgang an dem Mantel des Kegelversahlusses 6 angeordnet ist.

## Revendications

1. Procédé pour le traitement de déchets électroniques, **caractérisé en ce que** les composants métalliques réutilisables et d'autres composants réutilisables des déchets électroniques sont récupérés dans une seule ligne technologique ; ou
les métaux et d'autres composants utilisables sont récupérés séparément ;
de la façon suivante :
a/ pour la récupération de composants métalliques réutilisables et d'autres composants utilisables dans une seule ligne technologique, un produit broyé est préparé à partir de déchets électroniques contentant aussi des métaux et le produit broyé est chauffé dans un réacteur, de préférence à une température de 455-465 °C, les vapeurs des métaux de brasage sortant au-dessus de 200 °C sont amenées à sortir, précipitées par refroidissement, les métaux de brasage sont récupérés, le gaz généré dans le réacteur provenant de composants autres que les métaux est acheminé dans un dispositif de lavage alcalin, où il est purifié, la partie charbon du résidu de chauffage restant au fond du réacteur est amenée à sortir et le résidu de chauffage polymère est traité avec une solution acide, ou
b/ pour la récupération de métaux et d'autres composants réutilisables séparément, les métaux sont enlevés de la surface des déchets électroniques pour être traités par frottement-broyage, la séparation du cuivre, du nickel et des métaux nobles est effectuée électriquement avec un procédé connu, de cette manière une masse fondue prouvant être évacuée est obtenue, à une température plus élevée les métaux de brasage contenant du plomb sont récupérés sous forme d'une masse fondue secondaire, les métaux sont séparés et la fraction légère est concassée, chauffée dans un réacteur à basse température, afin que la résine soit récupérée, les vapeurs générées sont amenées à sortir, refroidies, la résine solidifiée est récupérée, le produit de fond du réacteur est traité avec de l'acide nitrique et le résidu solide est séparé,

2. Procédé selon la revendication 1, **caractérisé en ce que** des cartes de circuit imprimé sont traitées en tant que déchets électroniques.

3. Equipement pour traiter des déchets électroniques, comprenant une partie inférieure contenant une chambre (8) du four et un dôme de four (12) qui a une aube d'agitation (5) et un moteur d'entraînement (15) monté sur son arbre (10) et a un bloc de brûleur (4), une cavité de four, et des éléments pour emmener ailleurs les produits, et à l'intérieur de sa vis d'alimentation (14) il y a un verrou en forme de plaque (13), l'unité centrale du réacteur est le boîtier de roulement du moteur d'entraînement, contenant une boîte à garniture double (26, 27, 28 et 29) et à partie intérieure de son mécanisme d'agitation est un agitateur à ancre, comprend des pelles de dragage (5), sur le fond en forme de tronc conique du réacteur il y a un trou d'évacuation, fermé par un verrou conique (6) et le trou d'évacuation se poursuit en un goulot vertical (10).

4. Equipement selon la revendication 3, dont l'élément de fermeture (13) est un verrou en forme ce plaque, avec une paire de ressorts (22) située sur son bord.

5. Equipment selon la revendication 3 ou 4, dans lequel, dans l'embouchure de la sortie de vapeur (17), située sur le dôme de four (12), il y a un élément d'étranglement (18).

6. Equipement selon l'une quelconque des revendications 3 à 5, dans lequel les pelles de dragage (5) ont deux profils, l'un d'eux étant un profil de lame et l'autre étant un profil de poussée.

7. Equipment selon l'une quelconque des revendications 3 à 6, dans lequel il y a un trajet en spirale (20) avec un fil rond sur le parement du verrou conique (6).
